# FASCICULE DE BREVET EUROPEEN

(11) **EP 0 379 450 B1**
(45) Date de publication et mention de la délivrance du brevet: **15.12.1993**
(21) Numéro de dépôt: 90420020.1
(22) Date de dépôt: 12.01.1990
(51) Int. Cl.: H01L 21/82, H01L 27/088

(54) **Procédé de fabrication de circuits intégrés à transistors de mémoire EPROM et à transistors logiques**
Verfahren zur Herstellung von integrierten Schaltungen mit EPROM-Speicher-Transistoren und logischen Transistoren
Process for manufacturing integrated circuits using EPROM memory transistors and logic transistors

(30) Priorité: 17.01.1989 FR 8901227
(43) Date de publication de la demande: 25.07.1990
(73) Titulaire: SGS-THOMSON MICROELECTRONICS S.A., 94250 Gentilly (FR)
(72) Inventeur: Bergemont, Albert, F-38700 La Tronche (FR)
(74) Mandataire: de Beaumont, Michel

(56) Documents cités:
- FR-A- 2 618 011
- GB-A- 2 156 586
- US-A- 4 663 645
- US-A- 4 775 642
- PATENT ABSTRACTS OF JAPAN, vol. 11, no. 195 (E-518)[2642], 23 juin 1987; & JP-A-62 23 150
- PATENT ABSTRACTS OF JAPAN, vol. 11, no. 309 (E-547)[2756], 8 octobre 1987; & JP-A-62 101 068

## Description

La présente invention concerne le domaine de la fabrication des circuits intégrés de type MOS, et plus particulièrement la fabrication des circuits intégrés comprenant des transistors à grille flottante de mémoire non-volatile électriquement programmable (mémoire EPROM) et des transistors logiques.

Dans de tels circuits intégrés, les grilles flottantes des transistors de mémoire EPROM sont constituées par un premier niveau de silicium polycristallin. Une couche d'oxyde de grille sépare ces grilles flottantes du substrat de silicium sur lequel les transistors sont réalisés.

Des lignes de mot, formées par un deuxième niveau de silicium polycristallin, passent au-dessus des grilles flottantes et font office de grille de commande des transistors de mémoire à l'emplacement de ces transistors. Une couche d'isolement, également appelée couche d'oxyde interpoly, est située entre les lignes de mot et les grilles flottantes.

Les transistors logiques comportent une grille réalisée avec le deuxième niveau de silicium polycristallin utilisé pour former les lignes de mot de la mémoire. Ces grilles de transistors logiques sont séparées du substrat par une deuxième couche d'oxyde de grille différente de celle située sous la grille flottante des transistors de mémoire.

Les sources et drains des transistors de mémoire sont constitués par des zones à dopage élevé. Les sources et drains des transistors logiques sont formés par deux régions, une première région peu dopée et une deuxième région fortement dopée incluse dans la première région.

Une couche d'isolement supplémentaire est formée et des contacts sont réalisés par gravure de cette couche d'isolement supplémentaire. Un niveau de métal est déposé et gravé pour former notamment dans la zone mémoire des lignes de bit croisant les lignes de mot, tout en étant isolées d'elles, et contactant les drains des transistors de mémoire.

Dans le procédé de fabrication classique, les étapes suivantes se suivent et sont nettement séparées :
- réaliser les sources et drains des transistors de mémoire,
- former la première région peu dopée des sources et drains des transistors logiques,
- réaliser des espaceurs sur les bords latéraux des grilles de ces transistors logiques, et
- former la deuxième région fortement dopée des sources et drains des transistors logiques.

Cet état de la technique est, par example, décrit dans les documents US-A-4 775 642 et US-A-4 663 645.

La présente invention vise à fournir un procédé de fabrication au cours duquel on réalise simultanément d'une part une encapsulation isolante autour des empilements de niveaux de silicium polycristallin constituant les grilles flottantes et les grilles de commande des transistors de mémoire et d'autre part les espaceurs sur les bords latéraux des grilles des transistors logiques.

Les encapsulations isolantes permettent de réaliser des contacts autoalignés par rapport aux empilements de niveaux de silicium polycristallin qu'elles entourent, et un gain en densité de transistors est obtenu.

Le fait que la réalisation des encapsulations isolantes et des espaceurs soit simultanée présente l'avantage de diminuer le nombre d'étapes technologiques de fabrication.

Pour atteindre ces objets, la présente invention prévoit un procédé de fabrication de circuits intégrés de type MOS qui comportent des transistors à grille flottante de mémoire et des transistors logiques, comprenant les étapes suivantes :
a) réaliser des zones d'oxyde épais,
b) réaliser entre les zones d'oxyde épais une première couche d'oxyde de grille, et déposer un premier niveau de silicium polycristallin et une première couche d'isolement,
c) graver à l'emplacement des transistors logiques la première couche d'isolement, le premier niveau de silicium polycristallin et la première couche d'oxyde de grille,
d) réaliser une deuxième couche d'oxyde de grille et déposer un deuxième niveau de silicium polycristallin,
e) déposer une deuxième couche d'isolement,
f) graver à l'emplacement des transistors de mémoire et des transistors logiques la deuxième couche d'isolement et le deuxième niveau de silicium polycristallin,
g) graver dans la zone mémoire, à l'aplomb de la deuxième couche d'isolement et du deuxième niveau de silicium polycristallin gravés à l'étape précédente, la première couche d'isolement et le premier niveau de silicium polycristallin
h) réaliser les sources et drains, de dopage élevé, des transistors de mémoire par implantation,
i) réaliser à l'emplacement des sources et drains des transistors logiques une première région peu dopée par implantation,
j) éliminer la deuxième couche d'isolement à l'emplacement des transistors logiques,
k) déposer une troisième couche d'isolement qui est ensuite gravée sur l'ensemble du circuit de façon anisotrope en laissant dans la zone mémoire des zones de flanc sur les bords latéraux des empilements de premier et deuxième niveaux de silicium polycristallin et en laissant, à l'emplacement des transistors logiques, des espaceurs sur les bords latéraux des parties de deuxième niveau de silicium polycristallin présentes,
l) réaliser à l'emplacement des sources et drains des transistors logiques une deuxième région fortement dopée par implantation,
m) déposer dans la zone mémoire une couche de nitrure de silicium, déposer sur l'ensemble du circuit une quatrième couche d'isolement, réaliser par gravure de la quatrième couche d'isolement des contacts dans la zone mémoire et à l'emplacement des transistors logiques, les contacts dans la zone mémoire étant autoalignés par rapport aux empilements de premier et deuxième niveaux de silicium polycristallin, et déposer une couche de métal.

Ces objets, caractéristiques et avantages ainsi que d'autres de la présente invention seront exposés plus en détail dans la description suivante d'un mode de réalisation particulier faite en relation avec les figures jointes 1 à 6 qui représentent des étapes d'un procédé de fabrication de circuits intégrés selon l'invention.

De façon générale, comme cela est classique dans la représentation des circuits intégrés, on notera que les diverses figures ne sont pas représentées à l'échelle ni d'une figure à l'autre, ni à l'intérieur d'une figure, et notamment que les épaisseurs des couches sont dessinées arbitrairement dans le but de faciliter la lecture des figures.

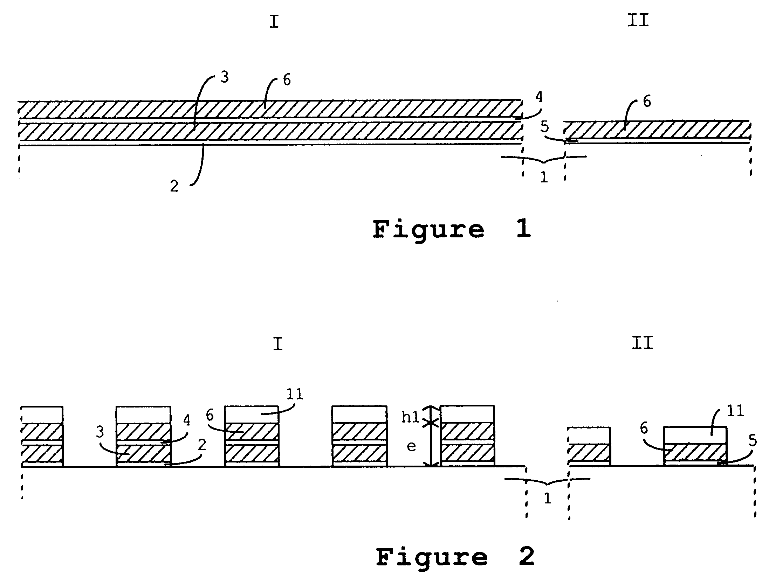

La figure 1 représente, à une étape de fabrication intermédiaire, une vue en coupe d'un circuit intégré comprenant des transistors à grille flottante de mémoire EPROM et des transistors logiques. Les dispositifs sont réalisés sur un substrat 1. Des zones d'oxyde épais, qui n'apparaissent pas sur les figures, ont été formées. Entre chaque zone d'oxyde épais a été réalisée une première couche d'oxyde de grille 2. Un premier niveau de silicium polycristallin 3 et une première couche d'isolement 4 ont ensuite été déposés. Après masquage de la zone mémoire (partie I sur les figures), la couche d'isolement 4, le niveau de silicium polycristallin 3 et la couche d'oxyde de grille 2 ont été éliminés à l'emplacement des transistors logiques (partie II sur les figures). Le masquage a été enlevé, et on a réalisé une deuxième couche d'oxyde de grille 5 sur l'ensemble du circuit (cette deuxième couche d'oxyde de grille se confond dans la zone mémoire avec la couche d'isolement 4). Un deuxième niveau de silicium polycristallin 6 a ensuite été déposé.

A l'étape de la figure 2, on a déposé une deuxième couche d'isolement 11 et on a gravé, à l'emplacement des transistors de mémoire et des transistors logiques, cette deuxième couche d'isolement 11 et le deuxième niveau de silicium polycristallin 6. La couche d'isolement 4 et le niveau de silicium polycristallin 3 ont été gravés dans la zone mémoire à l'aplomb de la couche d'isolement 11 et du niveau de silicium polycristallin 6 gravés précédemment. Les couches d'oxyde de grille 2 et 5 ont été éliminées à l'emplacement des sources et drains des transistors.

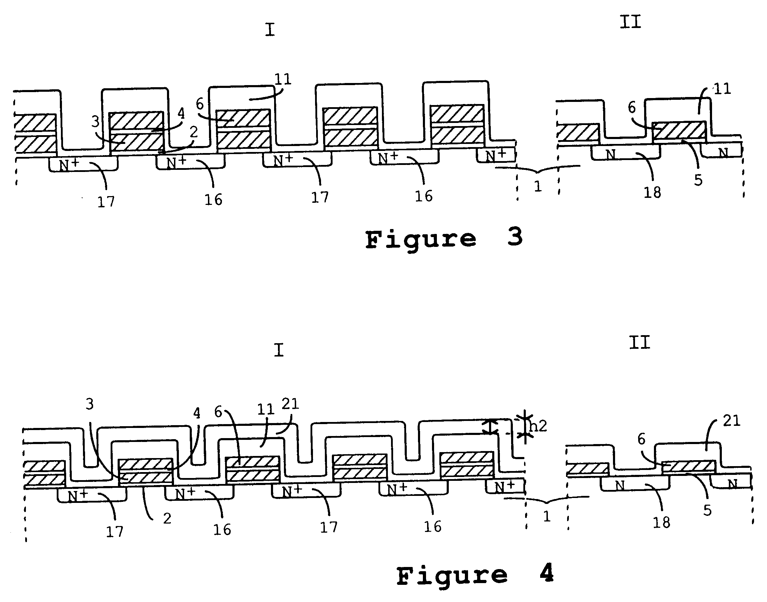

A l'étape de la figure 3, le circuit a subi une réoxydation. Les sources 16 et drains 17, de dopage N⁺ par exemple, des transistors de mémoire ont été réalisés par implantion. Une première région 18 peu dopée, de dopage N par exemple, faisant partie des sources et drains des transistors logiques a également été réalisée par implantation.

En figure 4, la deuxième couche d'isolement 11 a été éliminée à l'emplacement des transistors logiques. Une troisième couche d'isolement 21 a été déposée sur l'ensemble du circuit.

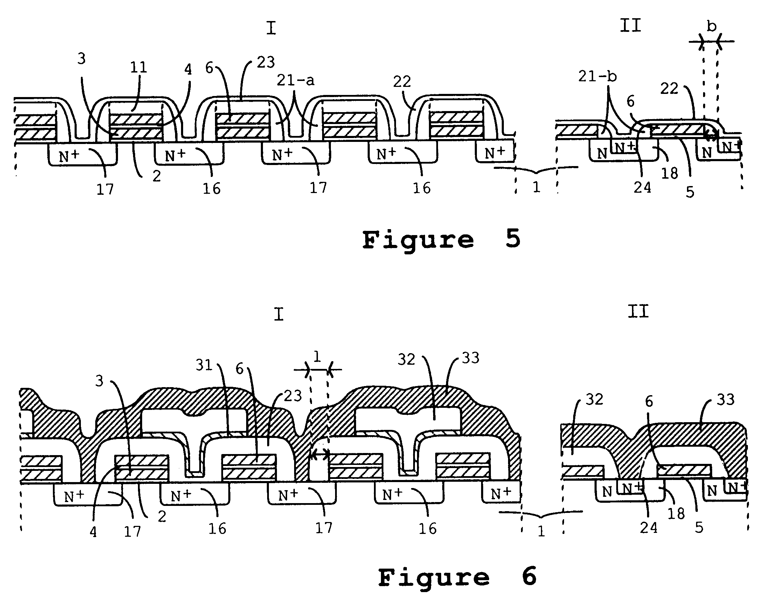

A l'étape de la figure 5, la troisième couche d'isolement 21 a été gravée de façon anisotrope Dans la zone mémoire, il reste de cette couche d'isolement 21 des zones de flanc 21-a sur les bords latéraux des empilements formés par les premier et deuxième niveaux de silicium polycristallin 3 et 6 et les première et deuxième couches d'isolement 4 et 11 respectivement. A l'emplacement des transistors logiques, il reste de la troisième couche d'isolement 21 des espaceurs 21-b sur les bords latéraux des parties de silicium polycristallin 6 présentes. Une oxydation a ensuite été réalisée sur l'ensemble du circuit. Il en résulte une fine couche d'oxyde 22.

Des pointillés ont été rajoutés sur la figure 5 pour indiquer la séparation entre les zones de flanc 21-a et la deuxième couche d'isolement 11 dans la zone mémoire. Les zones de flanc 21-a et la couche d'isolement 11 forment une encapsulation isolante 23 autour de chaque empilement de niveaux de silicium polycristallin dans cette zone mémoire.

Une deuxième région fortement dopée 24 a été réalisée à l'emplacement des sources et drains des transistors logiques par implantation pour en achever la formation.

A l'étape de la figure 6, une couche de nitrure de silicium 31 a été déposée dans la zone mémoire et une quatrième couche d'isolement 32 a été déposée sur l'ensemble du circuit. Cette couche d'isolement 32 est par exemple réalisée en oxyde de silicium dopé au bore et au phosphore (BPSG) que l'on fait fluer lors d'un traitement thermique à une température de l'ordre de 800°C. Des contacts ont été formés par gravure de la couche de BPSG 32 (dans la zone mémoire, les contacts sont réalisés au niveau des drains 17 des transistors). La couche de BPSG subit de nouveau un fluage par traitement thermique autour de 800°C. La couche de nitrure de silicium 31 ainsi que l'oxyde présents à l'emplacement des contacts sont éliminés. Une couche de métal 33 est ensuite déposée.

Les contacts réalisés dans la zone mémoire sont autoalignés par rapport aux empilements de premier et de deuxième niveaux de silicium polycritallin.

De préférence, la deuxième couche d'isolement 11 comporte une épaisseur h1 (figure 2) choisie de façon à optimiser la distance 1 (figure 6) entre le deuxième niveau de silicium polycristallin 6 et le métal 33 au niveau des contacts dans la zone mémoire. Pour cela, l'épaisseur h1 devra être de l'ordre de grandeur de la hauteur e (figure 2) de l'empilement comprenant les premier et deuxième niveaux de silicium polycristallin 3 et 6 et la couche d'isolement 4. Cela correspond à une hauteur e égale par exemple à 600 nm.

La troisième couche d'isolement 21 comporte de préférence une épaisseur h2 (figure 4) choisie de façon à optimiser la largeur b (figure 5) de la base des espaceurs 21-b à l'emplacement des transistors logiques.

Le mode de réalisation du procédé selon l'invention décrit avec les figures présente comme transistors logiques des transistors à canal N. Le circuit intégré peut comprendre à la fois des transistors logiques à canal N et des transistors logiques à canal P dans le cadre d'une technologie CMOS. Dans ce cas, des régions peu dopées P sont réalisées à l'emplacement des sources et drains des transistors logiques à canal P après la réalisation des régions peu dopées N, puis des régions fortement dopées P⁺ sont formées après la réalisation des régions fortement dopées N⁺ des transistors logiques à canal N.

## Revendications

1. Procédé de fabrication de circuits intégrés de type MOS qui comportent des transistors à grille flottante de mémoire et des transistors logiques, comprenant les étapes suivantes :
a) réaliser des zones d'oxyde épais,
b) réaliser entre les zones d'oxyde épais une première couche d'oxyde de grille (2), et déposer un premier niveau de silicium polycristallin (3) et une première couche d'isolement (4),
c) graver à l'emplacement des transistors logiques la première couche d'isolement (4), le premier niveau de silicium polycristallin (3) et la première couche d'oxyde de grille (2),
d) réaliser une deuxième couche d'oxyde de grille (5) et déposer un deuxième niveau de silicium polycristallin (6),
caractérisé en ce qu'il comprend en outre les étapes suivantes :
e) déposer une deuxième couche d'isolement (11),
f) graver à l'emplacement des transistors de mémoire et des transistors logiques la deuxième couche d'isolement (11) et le deuxième niveau de silicium polycristallin (6),
g) graver dans la zone mémoire, à l'aplomb de la deuxième couche d'isolement (11) et du deuxième niveau de silicium polycristallin (6) gravés à l'étape précédente, la première couche d'isolement (4) et le premier niveau de silicium polycristallin (3),
h) réaliser les sources (16) et drains (17), de dopage élevé, des transistors de mémoire par implantation,
i) réaliser à l'emplacement des sources et drains des transistors logiques une première région (18) peu dopée par implantation,
j) éliminer la deuxième couche d'isolement (11) à l'emplacement des transistors logiques,
k) déposer une troisième couche d'isolement (21) qui est ensuite gravée sur l'ensemble du circuit de façon anisotrope en laissant dans la zone mémoire des zones de flanc (21-a) sur les bords latéraux des empilements de premier et deuxième niveaux de silicium polycristallin et en laissant, à l'emplacement des transistors logiques, des espaceurs (21-b) sur les bords latéraux des parties de deuxième niveau de silicium polycristallin présentes
l) réaliser à l'emplacement des sources et drains des transistors logiques une deuxième région (24) fortement dopée par implantation,
m) déposer dans la zone mémoire une couche de nitrure de silicium (31), déposer sur l'ensemble du circuit une quatrième couche d'isolement (32), réaliser par gravure de la quatrième couche d'isolement (32) des contacts dans la zone mémoire et à l'emplacement des transistors logiques, les contacts dans la zone mémoire étant autoalignés par rapport aux empilements de premier et deuxième niveaux de silicium polycristallin, et déposer une couche de métal (33).

2. Procédé de fabrication de circuits intégrés selon la revendication 1, caractérisé en ce que la deuxième couche d'isolement (11) a une épaisseur (h1) choisie de façon à optimiser la distance (1) entre le deuxième niveau de silicium polycristallin (6) et le métal (33) au niveau des contacts dans la zone mémoire.

3. Procédé de fabrication de circuits intégrés selon la revendication 1, caractérisé en ce que la troisième couche d'isolement (21) a une épaisseur (h2) choisie de façon à optimiser la largeur (b) de la base des espaceurs (21-b) à l'emplacement des transistors logiques.

4. Procédé de fabrication de circuits intégrés selon la revendication 1, caractérisé en ce que, à l'étape i), un premier ensemble de régions peu dopées d'un premier type de conductivité et un deuxième ensemble de régions peu dopées du deuxième type de conductivité soient réalisés par deux implantations successives, et en ce que, à l'étape 1), un premier ensemble de régions fortement dopées du premier type de conductivité et un deuxième ensemble de régions fortement dopées du deuxième type de conductivité soient réalisés par deux implantations successives, pour former des transistors logiques à canal N et des transistors logiques à canal P dans le cadre d'une technologie CMOS.

## Patentansprüche

1. Verfahren zum Herstellen von integrierten MOS-Schaltkreisen, welche Speichertransistoren mit schwimmendem Gate und logische Transistoren umfassen, welches die folgenden Schritte umfaßt:
a) Realisieren von Gebieten mit dickem Oxid,
b) Realisieren einer ersten Gate-Oxidschicht (2) zwischen den Gebieten mit dickem Oxid und Aufbringen eines ersten Niveaus von polykristallinem Silicium (3) und einer ersten Isolationsschicht (4),
c) Ätzen der ersten Isolationsschicht (4), des ersten Niveaus von polykristallinem Silicium (3) und der ersten Gate-Oxidschicht (2) an der Stelle der logischen Transistoren,
d) Realisieren einer zweiten Gate-Oxidschicht (5) und Aufbringen eines zweiten Niveaus von polykristallinem Silicium (6),
dadurch **gekennzeichnet,** daß es außerdem die folgenden Schritte umfaßt:
e) Aufbringen einer zweiten Isolationsschicht (11),
f) Ätzen der zweiten Isolationsschicht (11) und des zweiten Niveaus von polykristallinem Silicium (6) an der Stelle der Speichertransistoren und der logischen Transistoren,
g) Ätzen der ersten Isolationsschicht (4) und des ersten Niveaus von polykristallinem Silicium (3) in dem Speicherbereich senkrecht zu der zweiten Isolationsschicht (11) und des zweiten Niveaus von polykristallinem Silicium (6), die im vorangehenden Schritt geätzt wurden,
h) Realisieren der Sources (16) und Drains (17) der Speichertransistoren mit hoher Dotierung durch Implantation,
i) Realisieren eines ersten wenig dotierten Bereichs (18) an der Stelle der Sources und Drains der logischen Transistoren durch Implantation,
j) Beseitigen der zweiten Isolationsschicht (11) am Ort der logischen Transistoren,
k) Aufbringen einer dritten Isolationsschicht (21), welche anschließend über der Gesamtheit des Schaltkreises anisotrop geätzt wird, wobei in dem Speicherbereich Flankenbereiche (21-a) am seitlichen Rand der Schichtung des ersten und zweiten Niveaus von polykristallinem Silicium zurückgelassen werden und am Ort der logischen Transistoren Abstandshalter (21-b) an den seitlichen Rändern der vorhandenen Abschnitte des zweiten Niveaus von polykristallinem Silicium zurückgelassen werden,
l) Realisieren eines zweiten, stark dotierten Gebiets (24) an der Stelle der Sources und Drains der logischen Transistoren durch Implantation,
m) Aufbringen einer Schicht aus Siliciumnitrid (31) im Speicherbereich, Aufbringen einer vierten Isolationsschicht (32) über dem gesamten Schaltkreis, Realisieren von Kontakten in dem Speicherbereich und am Ort der logischen Transistoren durch Ätzen der vierten Isolationsschicht (32), wobei die Kontakte in dem Speicherbereich bezüglich der Schichtung des ersten und zweiten Niveaus von polykristallinem Silicium selbstjustiert sind, und Aufbringen einer Metallschicht (33).

2. Verfahren zur Herstellung von integrierten Schaltkreisen nach Anspruch 1, dadurch **gekennzeichnet**, daß die zweite Isolationsschicht (11) eine Dicke (h1) aufweist, die derart gewählt ist, daß der Abstand (1) zwischen dem zweiten Niveau von polykristallinem Silicium (6) und dem Metall (33) auf der Ebene der Kontakte in dem Speicherbereich optimiert wird.

3. Verfahren zur Herstellung von integrierten Schaltkreisen nach Anspruch 1, daduch **gekennzeichnet**, daß die dritte Isolationsschicht (21) eine Dicke (h2) aufweist, die derart gewählt ist, daß die Breite (b) der Basis der Abstandshalter (21-b) am Ort der logischen Transistoren optimiert wird.

4. Verfahren zur Herstellung von integrierten Schaltkreisen nach Anspruch 1, dadurch **gekennzeichnet**, daß im Schritt i) eine erste Gruppe von wenig dotierten Bereichen eines ersten Leitungstyps und eine zweite Gruppe von wenig dotierten Bereichen des zweiten Leitungstyps durch zwei aufeinanderfolgende Implantationen realisiert werden, und daß im Schritt 1) eine erste Gruppe von stark dotierten Bereichen des ersten Leitungstyps und eine zweite Gruppe von stark dotierten Bereichen des zweiten Leitungstyps durch zwei aufeinanderfolgende Implantationen realisiert werden, um logische N-Kanal-Transistoren und logische P-Kanal-Transistoren im Rahmen einer CMOS-Technik zu bilden.

## Claims

1. A method of manufacturing MOS-type integrated circuits that include memory floating gate transistors and logic transistors, comprising the following steps:
a) forming thick oxide areas,
b) forming, between the thick oxide areas, a first gate oxide layer (2), and depositing a first polysilicon level (3) and a first isolation layer (4),
c) etching in the area of the logic transistors the first isolation layer (4), the first polysilicon level (3) and the first gate oxide layer (2),
d) forming a second gate uxide layer (5) and depositing a second polysilicon level (6),
characterized in that it further comprises:
e) depositing a second isolation layer (11),
f) etching in the area of the memory transistors and logic transistors the second isolation layer (11) and the second polysilicon level (6),
g) etching in the memory area, vertically with respect to the second isolation layer (11) and second polysilicon level (6) etched during the former step, the first isolation layer (4) and the first polysilicon level (3),
h) implanting heavily doped sources (16) and drains (17) of the memory transistors,
i) implanting, at the position of the logic transistor sources and drains, a first low doped region (18),
j) removing the second isolation layer (11) in the area of the logic transistors,
k) depositing a third isolation layer (21) which is then anisotropically etched on the whole circuit while leaving in the memory area lateral regions (21-a) on the lateral edges of the sandwiches of the first and second polysilicon levels and leaving, in the area of the logic transistors, spacers (21-b) on the lateral edges of the remaining portions of the second polysilicon level,
l) implanting at the position of the logic transistor sources and drains a second heavily doped region (24),
m) depositing in the memory area a silicon nitride layer (31), depositing on the whole circuit a fourth isolation layer (32), etching contact regions in the fourth isolation layer (32) in the memory area and at the position of the logic transistors, the contacts in the memory area being self-aligned with respect to the sandwiches of the first and second polysilicon levels, and depositing a metal layer (33).

2. A method of manufacturing integrated circuits according to claim 1, characterized in that the second isolation layer (11) has a thickness (h1) chosen to optimize the distance (1) between the second polysilicon level (6) and the metal layer (33) at the contacts in the memory area.

3. A method of manufacturing integrated circuits according to claim 1, characterized in that the third isolation layer (21) has a thickness (h2) chosen to optimize the width (b) of the base of the spacers (21-b) at the position of the logic transistors.

4. A method of manufacturing integrated circuits according to claim 1, characterized in that, at step i), a first group of lightly doped regions of the first conductivity type and a second group of lightly doped regions of the second conductivity type are formed through two successive implantations and wherein, at step l), a first group of heavily doped regions of the first conductivity type and a second group of heavily doped regions of the second conductivity type are formed through two successive implantations, forming N-channel logic transistors and P-channel logic transistors of a CMOS technology.
